# EUROPÄISCHE PATENTSCHRIFT

(11) **EP 1 600 046 B1**
(45) Veröffentlichungstag und Bekanntmachung des Hinweises auf die Patenterteilung: **28.06.2006**
(21) Anmeldenummer: 03785551.7
(22) Anmeldetag: 05.12.2003
(51) Int. Cl.: H05K 13/04

(54) **VORRICHTUNG ZUM BESTÜCKEN VON SUBSTRATEN MIT ELEKTRONISCHEN BAUELEMENTEN**
DEVICE FOR ASSEMBLING SUBSTRATES WITH ELECTRONIC COMPONENTS
DISPOSITIF D'INSERTION DE COMPOSANTS ELECTRIQUES DANS DES SUBSTRATS

(30) Priorität: 06.03.2003 DE 10309879
(43) Veröffentlichungstag der Anmeldung: 30.11.2005
(73) Patentinhaber: SIEMENS AKTIENGESELLSCHAFT, 80333 München (DE)
(72) Erfinder: ANDERSCH, Walter, 85551 Kirchheim (DE)
(86) Internationale Anmeldenummer: PCT/DE2003/004007
(87) Internationale Veröffentlichungsnummer: WO 2004/080143

(56) Entgegenhaltungen:
- WO-A-00/36896
- WO-A-00/54563
- WO-A-98/37744

## Beschreibung

Die Erfindung bezieht sich auf eine Vorrichtung zum Bestücken von Substraten mit elektrischen Bauelementen mittels eines in einer Arbeitsebene verfahrbaren Bestückkopfes, wobei ein in einer stationären Längsführung verfahrbare Positionierarm eine lineare Querführung für den Bestückkopf aufweist.

Eine derartige Bestückvorrichtung ist z. B. durch die WO 9837744 A bekannt geworden. Danach ist der freiragende Positionierarm balkenartig ausgebildet und an einem Ende an einem Fußteil verankert, das in einer stationären Längsführung mittels eines Linearmotors verfahrbar ist, dessen Mobilteil in das Fußteil integriert ist. Der senkrecht zur Längsführung abstehende Positionierarm weist ferner eine Querführung auf, in der ein Revolverbestückkopf verfahrbar ist. Bisher war es üblich, einen derartigen Bestückkopf mittels eines im Fußteil angetriebenen Zahnriemens zu verschieben. Die Längsführung und die Querführung bilden eine Arbeitsebene, in der der Bestückkopf zwischen Zuführmodulen für die Bauelemente und einer in einem Bestückbereich fixierten Leiterplatte verfahrbar ist, um die den Zuführmodulen entnommenen Bauelemente positionsgenau auf der Leiterplatte absetzen zu können.

Um eine hohe Bestückleistung zu erreichen, wird der Positionierarm bis zum 4-fachen der Erdanziehung beschleunigt und abgebremst. Insbesondere wenn sich der Bestückkopf am äußeren Ende des stählernen Positionierarms befindet, wird dieser stark ausgelenkt. Die dadurch verursachten Schwingungen müssen hinreichend abklingen, bevor das Bauelement positionsgenau auf die Leiterplatte aufgesetzt werden kann, was mit einer entsprechenden Verzögerung verbunden ist.

Der Erfindung liegt die Aufgabe zügrunde, die Bestückleistung zu erhöhen.

Diese Aufgabe wird durch die Erfindung gemäß Anspruch 1 gelöst. Das verwendete CFK-Material (CFK = carbonfaserverstärkter Kunststoff) hat ein spezifisches Gewicht, das annähernd 1/5 des spezifischen Gewichts von Stahl aufweist. Da der Elastititätsmodul nur geringfügig unter dem des Stahls liegt, kann der Positionierarm mit einem größeren Querschnitt und geringerer Masse erhebliche biegesteifer ausgebildet werden. Dadurch verringern sich die Schwingungsamplitude und die Nachschwingdauer erheblich.

Durch die Verwendung eines Linearmotors für den Antrieb des Bestückkopfes kann die Bewegung in dieser Richtung erheblich schneller und genauer gesteuert werden, was zu einer weiteren Steigerung der Bestückleistung führt. Ein Problem dabei sind jedoch die zwischen dem Bestückarm und dem Bestückkopf wirkenden magnetischen Zugkräfte, die durch seitliche Stützlager der Linearführung abgefangen werden. Diese relativ hohen Magnetkräfte bewirken jedoch eine lokale Verformung des Trägers, die die Positioniergenauigkeit zusätzlich beeinträchtigtigen könnte. Die Verstärkungselemente versteifen die Seitenwand derart, dass die durch die Magnetkräfte bewirkte Verformung gering bleibt.

Vorteilhafte Weiterbildungen der Erfindung sind in den Patentansprüchen 2 bis 9 gekennzeichnet.

Der am Positionierarm geführt Linearmotor hat den Nachteil, dass die vom Spulenteil entwickelte Betriebswärme den Positionierarm erwärmt. Dabei dehnen sich das CFK-Material und die Führungsschienen der Linearführung und die Magnetschiene unterschiedlich. Dieser Bimetalleffekt führt daher zu einer Biegeverformung des Positionierarmes, die die Positioniergenauigkeit erheblich beeinträchtigen kann. Durch eine effektive Kühlung des Spulenteils kann ein großer Teil der entstehenden Wärme abgeführt und insbesondere die Betriebstemperafür des Linearmotors erheblich abgesenkt werden, so dass die Auswirkung auf den Positionierarm unschädlich gering gehalten werden kann.

Die Weiterbildung nach Anspruch 3 hat den Vorteil, dass der Bestückkopf raumsparend unmittelbar auf das Spulenteil aufgesetzt wird und dass die von den Magnetkräften erzeugte Vorspannung eine definierte spielfreie Führung ermöglicht, die sich unmittelbar auch auf den Bestückkopf überträgt. Durch die Kühlung des Zwischenraums wird verhindert, dass die Betriebswärme des Spulenteils sich auf den Bestückkopf überträgt.

Durch den zweiten Linearmotor nach Anspruch 4 wird der Positionierarm in raumsparender Anordnung und unter Ausnutzung der magnetischen Vorspannung spielarm am Chassis der Bestückvorrichtung geführt. Der Linearmotor ermöglicht eine äußerst schnelle und genaue Verstellung. Dadurch, dass sich die Seitenwand durchgehend geradlinig bis zur Längsführung erstreckt, kann der Bestückkopf unter Ausnutzung der gesamten Länge des Positionierarmes bis unmittelbar an die Führungsschienen der Längsführung verfahren werden, wodurch sich die Arbeitsebene entsprechend vergrößert.

Der Träger nach Anspruch 5 stellt eine einfache, gewichtssparende und formstabile Bauform dar.

Der Träger nach Anspruch 6 kann mit geringem Vorrichtungsaufwand aus einfachen Elementen zusammengesetzt werden. Die fachwerkartig eingesetzten Verstärkungselemente stützten sich zwischen der den Linearmotor tragenden Seitenwand und der gegenüberliegenden Rückwand ab und versteifen den Bestückarm in dieser Richtung. Da die Verstärkungselemente in voller Breite an die Innenseite der Seitenwand angesetzt werden können, versteifen sie diese auch gegen die von den Magnetkräften erzeugten lokalen Verformungen.

Die Weiterbildung nach Anspruch 7 ermöglicht es, über die volle Länge des Positionierarmes gleichmäßig große Verstärkungselemente zu verwenden, die z. B. mit der Seitenwand verklebt werden.

Durch die Federelemente nach Anspruch 8 werden Abstandsänderungen zwischen den Führungsschienen und den Führungselementen ausgeglichen und dadurch Verspannungen zwischen den Führungselementen und Führungsschienen vermieden.

Im Folgenden wird die Erfindung anhand eines in der Zeichnung dargestellten Ausführungsbeispieles näher erläutert.

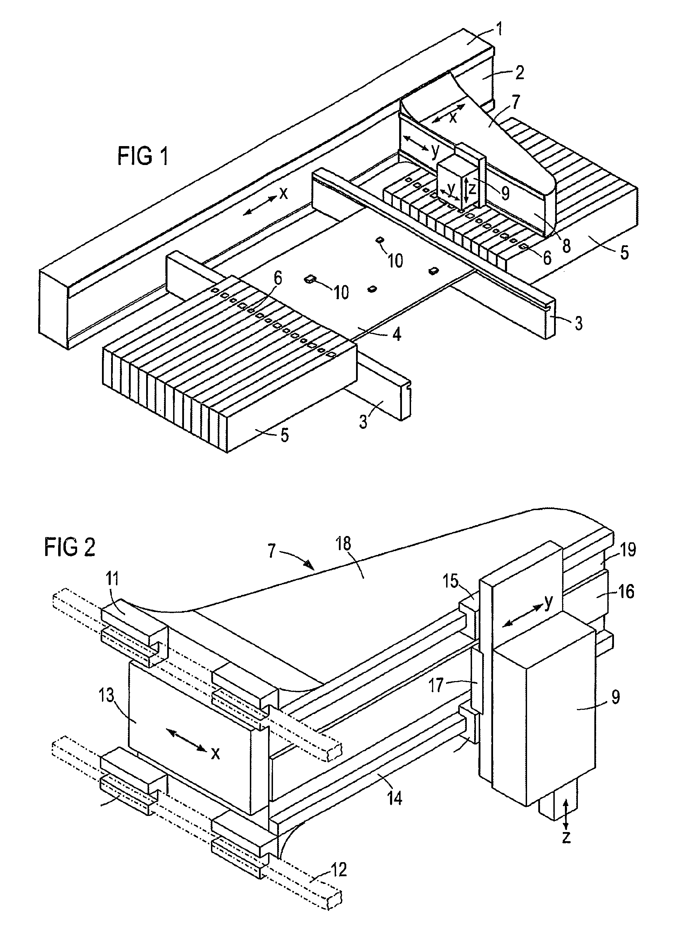

Nach Figur 1 weist ein trägerartiges Chassis-Teil 1 eine waagerecht verlaufende lineare Längsführung 2 auf, die sich in einer Koordinatenrichtung X erstreckt. An das Chassisteil 1 grenzt ein Tisch 3 an, auf dem ein als Leiterplatte ausgebildetes Substrat 4 fixiert ist. Zu beiden Seiten des Tisches sind Zuführmodule 5 für elektrische Bauelemente 10 angeordnet, deren Abholstellen 6 senkrecht zur Längsführung 2 aneinandergereiht sind. An der Längsführung 2 ist ein in der X-Richtung verschiebbarer Positionierarm 7 geführt, der freiragend senkrecht zur Längsführung 2 absteht und der eine waagerechte, in einer zur Längsführung 2 senkrechte Querführung 8 aufweist, in der ein Bestückkopf 9 in einer Y-Richtung verfahrbar ist.

An den Abholstellen 6 der Zuführmodule 5 werden die verschiedenen elektrischen Bauelemente 10 zur Abholung durch den Bestückkopf 9 bereitgestellt. Die Abholstellen 6 und das Substrat 4 befinden sich annähernd in einer Ebene, zu der die Greifer in einer senkrechten Z-Richtung auf und ab bewegt werden können. Der Bestückkopf 9 ist innerhalb der durch die X- und Y-Achse gebildeten Arbeitsebene zwischen den Abholstellen 6 und den Aufsetzstellen der Bauelemente 10 auf dem Substrat 4 verfahrbar, wobei die exakten Arbeitspositionen durch die entsprechende Positionierung des Positionierarms 7 in der Längsführung 2 sowie des Bestückkopfes 9 in der Querführung 8 eingestellt werden.

In Figur 2 ist der Positionierarm 7 mit seinen Führungen, Antrieben und dem Bestückkopf 9 näher dargestellt. Der Positionierarm 7 weist an seinem Fußteil Führungselemente 11 auf, die in parallele Führungsschienen 12 der stationären Längsführung 2 (Figur 1) eingreifen. Zwischen den Führungselementen 11 ist ein Mobilteil 13 eines zweiten Linearmotors angeordnet, dessen nicht dargestellte Magnetschiene zwischen den Führungsschienen 12 am Chassis-teil 1 verlaufend befestigt sind. Durch den Linearmotor ist der Positionierarm 7 schnell und präzise entlang der Führungsschienen 12 verfahrbar.

Am Positionierarm 7 sind senkrecht zu den Führungsschienen 12 weitere Führungsschienen 14 der Querführung 8 angeordnet, in denen weitere Führungselemente 15 des Bestückkopfes 9 verschiebbar sind. Zwischen den Führungsschienen 14 ist ferner eine Magnetschiene 16 angeordnet, die mit einem Spulenteil 17 des Bestückkopfes 9 einen ersten Linearmotor bildet, der den Bestückkopf 9 antreibt. Der Positionierarm 7 weist einen kastenartigen Träger 18 auf, an dem das Mobilteil 13, die Führungselemente 11 und an einer Seitenwand 19 die Magnetschiene 16 und die Führungsschienen 14 befestigt sind. Eine der Seitenwand 19 gegenüberliegende Rückseite des Trägers 18 verläuft schräg zur Seitenwand 19 derart, dass sich der Träger 18 vom Fußende zu seinem freien Ende hin verjüngt.

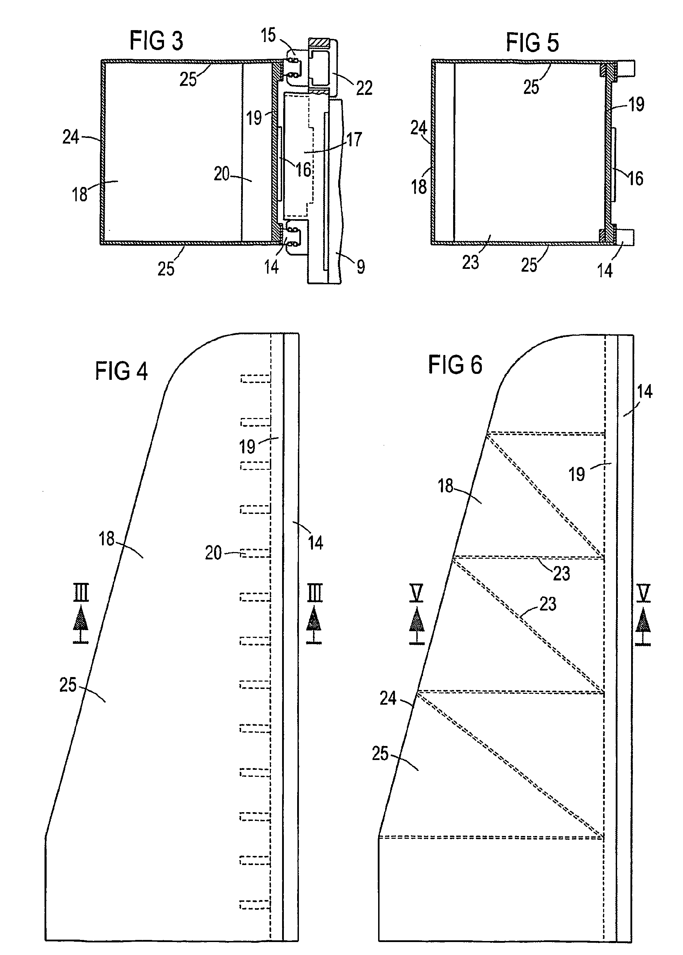

Nach den Figuren 3 und 4 ist der Träger 18 aus einzelnen Platten zusammengeklebt, die aus carbonfaserverstärktem Kunststoff bestehen, der üblich als CFK bezeichnet wird. Aus der Querschnittsdarstellung der Figur 3 ist erkennbar, dass die die Magnetschiene 16 tragende Seitenwand 19 verstärkt ausgebildet ist und zusätzlich durch über die gesamte Länge der Seitenwand 19 angeordnete rippenartige Verstärkungselemente 20 verstärkt ist, die sich über die gesamte Breite der Seitenwand 19 erstrecken. Zwischen dem Bestückkopf 9 und dem ihm zugeordneten Spulenteil 70 ist ein Zwischenraum 21 vorgesehen, der in nicht näher dargestellter Weise von einem Kühlmedium durchströmt werden kann, dass einen großen Teil der Betriebswärme des Spulenteils 17 abführt. Die der unteren Führungsschiene 14 zugeordneten Führungselemente 15 sind fest mit dem Bestückkopf 9 verbunden. Die der anderen Führungsschiene 14 zugeordneten Führungselemente 15 sind mit dem Bestückkopf 9 über abstandsausgleichende Federelemente 22 verbunden, die z. B. thermisch bedingte Abstandsschwankungen ausgleichen.

Zwischen der Seitenwand 19 und einer dieser gegenüberliegenden Rückwand 24 sind eine obere und eine untere Verbindungswand 25 angeordnet. Die Führungsschienen 14 sind am oberen bzw. unteren Rand der Seitenwand 19 in unmittelbarer Nähe der Verbindungswände 25 befestigt, die die Führungsschienen 14 besonders wirksam gegen Durchbiegung abstützen.

Die Figuren 5 und 6 zeigen den Träger 18 mit abgewandelten plattenförmigen Verstärkungselementen 23, die fachwerkartig im Inneren des Trägers 18 zwischen der Rückwand 24 und der Seitenwand 19 aneinandergereiht sind und diese gegen die Wirkung der Magnetkräfte verstärken.

### Bezugszeichen

- 1: Chassis-Teil
- 2: Längsführung
- 3: Tisch
- 4: Substrat
- 5: Zuführmodul
- 6: Abholstelle
- 7: Positionierarm
- 8: Querführung
- 9: Bestückkopf
- 10: Bauelement
- 11: Führungselement
- 12: Führungsschiene
- 13: Mobilteil
- 14: Führungsschiene
- 15: Führungselement
- 16: Magnetschiene
- 17: Spulenteil
- 18: Träger
- 19: Seitenwand
- 20: Verstärkungselement
- 21: Zwischenraum
- 22: Federelement
- 23: Verstärkungselement
- 24: Rückwand
- 25: Verbindungswand

## Patentansprüche

1. Vorrichtung zum Bestücken von Substraten (4) mit elektrischen Bauelementen (10) mittels eines in einer Arbeitsebene verfahrbaren Bestückkopfes (9),
wobei ein in einer stationären Längsführung (2) verfahrbarer Positionierarm (7) eine zu Längsführung (2) quer stehende lineare Querführung (8)für den Bestückkopf aufweist,
**dadurch gekennzeichnet,**
**dass** ein als Hohlkörper ausgebildeter Träger (18) des Positionierarms (7) aus carbonfaserverstärktem Kunststoff besteht,
**dass** der Bestückkopf (9) mittels eines ersten Linearmotors entlang der Querführung (8) bewegbar ist,
**dass** ein Stator des ersten Linearmotors durch eine am Träger befestigte Magnetschiene (16) gebildet ist,
**dass** ein mobiles Spulenteil (17) des ersten Linearmotors fest dem Bestückkopf (9) zugeordnet ist und
**dass** eine die Magnetschiene (16) tragende Seitenwand (19) des Trägers (18) Verstärkungselemente (20, 23) zum unmittelbaren Abfangen von zwischen der Magnetschiene und dem Spulenteil (17) wirkenden Magnetkräften aufweist.

2. Vorrichtung nach Anspruch 1, **dadurch gekennzeichnet,**
**dass** das Spulenteil (17) eine Kühleinrichtung zum Abführen der Betriebswärme aufweist.

3. Vorrichtung nach Anspruch 2, **dadurch gekennzeichnet,**
**dass** der Bestückkopf (9) unmittelbar auf ein Gehäuse für das Spulenteil (17) aufgesetzt ist und
**dass** ein Zwischenraum (21) zwischen dem Spulenteil (17) und dem Bestückkopf (9) vom einem Kühlmedium durchströmt wird.

4. Vorrichtung nach Anspruch 1, 2 oder 3, **dadurch gekennzeichnet,**
**dass** die Längsführung an einer Stirnseite des freiragenden Positionierarmes angeordnet ist,
**dass** die Querführung (8) an der bis zur Längsführung (2) durchgehenden geradlinigen Seitenwand (19) des Positionierarmes (7) angebracht ist.
**dass** der Längsführung (2) ein Stator eines zweiten Linearmotors zugeordnet ist und
**dass** der Positionierarm (7) ein Mobilteil (13) des zweiten Linearmotors aufweist.

5. Vorrichtung nach einem der Ansprüche 1 bis 4, **dadurch gekennzeichnet,**
**dass** der Träger (18) als sich zu seinem freien Ende hin verjüngender Kastenträger ausgebildet ist.

6. Vorrichtung nach Anspruch 4, **dadurch gekennzeichnet,**
**dass** der Träger (18) aus vorgeformten plattenartigen Einzelteilen zusammengeklebt ist und
**dass** die Verstärkungselemente (23) durch fachwerkartig an die Seitenwand (19) angesetzte, zur Querführung (8) schrägstehende Zwischenplatten gebildet sind.

7. Vorrichtung nach Anspruch 4, **dadurch gekennzeichnet,**
**dass** die rippenartigen Verstärkungselemente (20) entlang der Seitenwand (19) angeordnet sind.

8. Vorrichtung nach einem der vorhergehenden Ansprüche, **dadurch gekennzeichnet,**
**dass** die Längsführung (2) und/oder die Querführung (8) zwei zueinander parallelen Führungsschienen (12, 14) aufweist, an denen Führungselemente (11, 15) des Positionierarms (7) bzw. Bestückkopfes (9) geführt sind,
**dass** die einer der Führungsschienen (12, 14) zugeordneten Führungselemente (11, 15) fest mit dem Positionierarm bzw. Bestückkopf verbunden sind und
**dass** die der anderen Führungsschiene zugeordneten Führungselemente (11, 15) über abstandsausgleichende Federelemente (22) mit dem Positionierarm (7) bzw. Bestückkopf (9) verbunden sind.

9. Vorrichtung nach Anspruch 8, **dadurch gekennzeichnet, dass** die Führungsschienen (14) in der Nähe von oberen und unteren Verbindungswänden (25) angeordnet sind., die sich zwischen der Seitenwand (19) und einer Rückwand (24) des Trägers (18) erstrecken.

## Claims

1. Device for mounting electronic components (10) on substrates (4) by means of a placement head (9) that can be moved in one operating plane,
wherein a positioning arm (7) that is movable in a stationary longitudinal guide (2) has, for the placement head, a linear transverse guide (8) disposed perpendicularly to the longitudinal guide (2),
**characterised in that**
a hollow-construction support (18) of the positioning arm (7) consists of carbon fibre reinforced plastic,
**that** the placement head (9) can be moved along the transverse guide by means of a first linear motor (8),
**that** a stator of the first linear motor is formed by a magnet rail (16) attached to the support,
**that** a mobile coil section (17) of the first linear motor is permanently assigned to the placement head (9) and
**that** a side wall (19) of the support (18) carrying the magnet rail (16) has reinforcing elements (20, 23) for directly checking the magnetic forces exerted between the magnet rail and the coil section (17).

2. Device according to claim 1, **characterised in that**
the coil section (17) has a cooling apparatus for removing the operating heat.

3. Device according to claim 2, **characterised in that**
the placement head (9) is mounted directly on a housing for the coil section (17) and
**that** a cooling medium flows through an interspace (21) between the coil section (17) and the placement head (9).

4. Device according to claim 1, 2 or 3, **characterised in that**
the longitudinal guide is disposed on an end face of the freely extending positioning arm,
**that** the transverse guide (8) is mounted on the side wall (19) of the positioning arm (7) extending in a continuous straight line to the longitudinal guide (2),
**that** the longitudinal guide (2) is assigned a stator of a second linear motor and
**that** the positioning arm (7) has a mobile part (13) of the second linear motor.

5. Device according to one of the claims 1 to 4, **characterised in that**
the support (18) is implemented as a box beam narrowing towards its free end.

6. Device according to claim 4, **characterised in that**
the support (18) is bonded together from pre-shaped plate-like individual parts and
**that** the reinforcing elements (23) are formed by intermediate plates attached to the side wall (19) in a framework manner obliquely to the transverse guide (8).

7. Device according to claim 4, **characterised in that**
the rib-like reinforcing elements (20) are disposed along the side wall (19).

8. Device according to one of the preceding claims, **characterised in that**
the longitudinal guide (2) and/or the transverse guide (8) has/have two parallel guide rails (12, 14) on which guide elements (11, 15) of the positioning arm (7) and placement head (9) respectively are guided,
**that** the guide elements (11, 15) assigned to one of the guide rails (12, 14) are permanently connected to the positioning arm and placement head respectively and
**that** the guide elements (11, 15) assigned to the other guide rail are connected to the positioning arm (7) and placement head (9) respectively via spacing-compensating spring elements (22).

9. Device according to claim 8, **characterised in that** the guide rails (14) are disposed in proximity to upper and lower connecting walls (25) extending between the side wall (19) and a back wall (24) of the support (18).

## Revendications

1. Dispositif de montage de composants électriques (10) sur des substrats (4) au moyen d'une tête de montage (9) déplaçable dans un plan de travail,
un bras de positionnement (7) déplaçable dans un guidage longitudinal (2) stationnaire présentant un guidage transversal (8) linéaire situé transversalement par rapport au guidage longitudinal (2),
**caractérisé**
**en ce qu'**un support (18) du bras de positionnement (7), exécuté comme corps creux, est constitué de plastique renforcé par fibres de carbone,
**en ce que** la tête de montage (9) est déplaçable le long du guidage transversal (8) au moyen d'un premier moteur linéaire,
**en ce qu'**un stator du premier moteur linéaire est formé par un rail magnétique (16) fixé sur le support,
**en ce qu'**une pièce de bobine mobile (17) du premier moteur linéaire est associée de manière fixe à la tête de montage (9) et
**en ce qu'**une paroi latérale (19) du support (18), portant le rail magnétique (16), présente des éléments de renforcement (20, 23) pour intercepter directement des forces magnétiques agissant entre le rail magnétique et la pièce de bobine (17).

2. Dispositif selon la revendication 1, **caractérisé**
**en ce que** la pièce de bobine (17) présente un dispositif de refroidissement pour évacuer la chaleur de service.

3. Dispositif selon la revendication 2, **caractérisé**
**en ce que** la tête de montage (9) est posée directement sur un boîtier pour la pièce de bobine (17) et
**en ce qu'**un espace intermédiaire (21) entre la pièce de bobine (17) et la tête de montage (9) est traversé par un fluide de refroidissement.

4. Dispositif selon la revendication 1, 2 ou 3, **caractérisé en ce que** le guidage longitudinal est disposé sur un côté frontal du bras de positionnement dépassant librement,
**en ce que** le guidage transversal (8) est posé sur la paroi latérale (18), rectiligne de manière continue jusqu'au guidage longitudinal (2), du bras de positionnement (7),
**en ce qu'**un stator d'un deuxième moteur linéaire est associé au guidage longitudinal (2) et
**en ce que** le bras de positionnement (7) présente une pièce mobile (13) du deuxième moteur linéaire.

5. Dispositif selon l'une des revendications 1 à 4, **caractérisé**
**en ce que** le support (18) est exécuté comme poutre en caisson se rétrécissant vers son extrémité libre.

6. Dispositif selon la revendication 4, **caractérisé**
**en ce que** le support (18) est collé à partir de pièces détachées préformées en forme de plaques et
**en ce que** les éléments de renforcement (23) sont formés par des plaques intermédiaires posées en treillis contre la paroi latérale (19) et situées en biais par rapport au guidage transversal (8).

7. Dispositif selon la revendication 4, **caractérisé**
**en ce que** les éléments de renforcement (20) en forme de nervure sont disposés le long de la paroi latérale (19).

8. Dispositif selon l'une quelconque des revendications précédentes, **caractérisé**
**en ce que** le guidage longitudinal (2) et/ou le guidage transversal (8) présentent deux rails de guidage (12, 14) parallèles l'un à l'autre, sur lesquels sont guidés des éléments de guidage (11, 15) du bras de positionnement (7) resp. de la tête de montage (9),
**en ce que** les éléments de guidage (11, 15) associés à l'un des rails de guidage (12, 14) sont raccordés de manière fixe au bras de positionnement resp. à la tête de montage et
**en ce que** les éléments de guidage (11, 15) associés à l'autre rail de guidage sont raccordés au bras de positionnement (7) resp. à la tête de montage (9) au moyen d'éléments à ressort compensant un écart.

9. Dispositif selon la revendication 8, **caractérisé**
**en ce que** les rails de guidage (14) sont disposés à proximité de parois de raccordement (25) supérieures et inférieures qui s'étendent entre la paroi latérale (19) et une paroi arrière (24) du support (18).
